# EUROPÄISCHE PATENTANMELDUNG

(11) **EP 2 034 531 A2**
(43) Veröffentlichungstag der Anmeldung: **11.03.2009**
(21) Anmeldenummer: 08104855.5
(22) Anmeldetag: 24.07.2008
(51) Int. Cl.: H01L 41/04, H01L 41/22, F02M 51/06

(54) **Piezoaktormodul mit einem Schutzschichtsystem und ein Verfahren zu dessen Herstellung**

(30) Priorität: 06.09.2007 DE 102007042401
(71) Anmelder: Robert Bosch GmbH, 70442 Stuttgart (DE)
(72) Erfinder: Sommariva, Helmut, 8053 Graz (AT); Schaich, Udo, 70378 Stuttgart (DE); Schlegl, Nicole, 73635 Rudersberg (DE); Yilmazer, Cetin, 96052 Bamberg (DE)

(57) **Zusammenfassung**

Es wird ein Piezoaktormodul und ein Verfahren zu dessen Herstellung mit einem oder mehreren Piezoaktoren (2) vorgeschlagen, der oder die zwischen einem Aktorkopf (3) und einem Aktorfuß (4) eingespannt sind und wobei zumindest der Piezoaktor (2) mit einem Schutzschichtsystem (5) versehen ist. Es ist ein Umfassungselement (6) zur Befestigung des Schutzschichtsystems (5) am Aktorkopf (3), am Aktorfuß (4) und/oder am Piezoaktor (2) vorgesehen, das innen zur Anlage am Schutzschichtsystem (5) ein dichtendes Teil (8) aus elektrisch schlecht leitendem Material und außen ein Teil (7) aus elektrisch gut leitendem Material aufweist, das durch elektromagnetisches Umformen auf das innere Teil (8) pressbar ist.

## Beschreibung

### Stand der Technik

Die Erfindung betrifft ein Piezoaktormodul mit einem Schutzschichtsystem und ein Verfahren zu dessen Herstellung gemäß der Gattung des Hauptanspruchs und des nebengeordneten Verfahrensanspruchs.

Ein solches Piezoaktormodul kann beispielsweise in einem Piezoinjektor zur zeitpunkt- und mengengenauen Dosierung von Kraftstoff in einem Verbrennungsmotor eingesetzt werden. Der Piezoinjektor besteht im wesentlichen aus einem Haltekörper für das Piezoaktormodul und mindestens einem im Piezoaktormodul angeordneten Piezoaktor mit zwischen einem Aktorkopf und einem Aktorfuß angeordneten, übereinandergestapelten Piezoelementen, die jeweils aus mit Innenelektroden eingefassten Piezolagen bestehen.

Die Piezoelemente des Piezoaktors sind unter Verwendung eines Materials mit einer geeigneten Kristallstruktur (Piezokeramik) für die Piezolagen so aufgebaut, dass bei Anlage einer äußeren Spannung an die Innenelektroden eine mechanische Reaktion der Piezoelemente erfolgt, die in Abhängigkeit von der Kristallstruktur und der Anlagebereiche der elektrischen Spannung einen Druck oder Zug in eine vorgebbare Richtung darstellt. Der Piezoaktor ist bei einem Piezoinjektor mit einer Düsennadel verbunden, sodass durch Anlegen einer Spannung an die Piezoelemente eine Düsenöffnung freigegeben wird.

Diese Common Rail Injektoren können dabei so aufgebaut werden, dass eine indirekt vom Piezoaktor gesteuerte Düsennadel vorhanden ist, wobei der Piezoaktor direkt oder indirekt vom Druck des Kraftstoffs umgeben ist und zwischen der Düsennadel und dem Piezoaktor lediglich ein hydraulischer Kopplungsraum vorgesehen ist. Wenn die Piezoaktoren sich dabei im Niederdruckbereich des Kraftstoffs (ca. 60 bar) befinden, wie es bei indirekt gesteuerten Nadelbewegungen der Fall ist, so kann hier durchaus eine Metallhülsenabdichtung des Piezoaktors mit einer Membran als hub- und/oder temperaturausgleichendes Element realisiert werden.

In Diesel-Piezoinjektoren werden bei der so genannten direkten Düsennadelsteuerung die Piezoaktoren direkt im Dieselkraftstoff unter Hochdruck (ca. 2000 bar) betrieben, wobei die zuvor erwähnte relativ starre Hülsen-/Membranabdichtung den hohen Systemdrücken und den höheren Hubbewegungen des Piezoaktors unter den zur Verfügung stehenden Platzverhältnissen nicht standhalten würde.

Zum Schutz der Piezoelemente des Piezoaktors, beispielsweise auch im Hinblick auf deren elektrische Isolation, ist es daher auch bekannt, den Piezoaktor mit einem Elastomer zu umhüllen. Da die Anwesenheit von Kraftstoff, insbesondere hinsichtlich seiner leitfähigen Bestandteile, auf der Oberfläche des Piezoaktors zu einem elektrischen Überschlag zwischen den Elektroden und somit dem Versagen des Piezoaktors führen kann, muss der Piezoaktor vor dem direkten Kontakt mit dem Kraftstoff auch durch entsprechende Dichtheit an den Naht- oder Verbindungsstellen geschützt werden.

Aus der DE 101 39 871 A1 ist ein Piezoinjektor mit einem über einen hydraulischen Druckübersetzer auf ein Ventilglied einwirkenden Aktormodul bekannt, bei dem die Piezoelemente des Piezoaktors in einer mit einem metallischen Wellbalg versehenen Umhüllung angeordnet sind.

Aus der WO 2001 48834 A2 ist bekannt, dass die elektrische Isolation eines Piezoaktors mittels eines Schutzmantels aus Kunststoff vorgesehen wird, der beispielsweise durch Spritzgießen aufgebracht wird. Ferner ist aus der US 7 036 198 B2 bekannt, dass dieses Schutzschichtsystems aus einem Schrumpfschlauch gebildet wird, der durch einen Schrumpfprozess die Abdichtung gegenüber dem umgebenden Medium bewirkt.

Die kritischen Stellen der Abdichtung sind hierbei die Anbindungen der Enden der Umhüllung bzw. des Schutzschichtsystems insbesondere an den Aktorkopf und/oder an den Aktorfuß um auch hier eine gute Dichtheit dauerhaft zu gewährleisten.

Offenbarung der Erfindung

Die Erfindung geht von einem eingangs beschriebenen Piezoaktormodul mit einem oder mehreren Piezoaktoren aus, der oder die zwischen einem Aktorkopf und einem Aktorfuß eingespannt sind und wobei zumindest der Piezoaktor mit einem Schutzschichtsystem versehen ist. Gemäß der Erfindung ist ein Umfassungselement zur Befestigung des Schutzschichtsystems am Aktorkopf, am Aktorfuß und/oder am Piezoaktor vorgesehen, das innen zur Anlage am Schutzschichtsystem ein dichtendes Teil aus elektrisch vergleichsweise schlecht leitendem Material und außen ein Teil aus elektrisch gut leitendem Material aufweist, das durch elektromagnetisches Umformen auf das innere Teil pressbar ist. Das Schutzschichtsystem kann dabei aus einem oder mehreren Schichten eines polymeren oder metallischen Materials bestehen.

Das elektromagnetische Umformverfahren ist für sich gesehen beispielsweise aus der DE 20 2004 014 6582 U1 bekannt, in der beschrieben ist, wie das elektromagnetische Umformen bei elektrisch und/oder magnetisch leitenden Werkstücken derat vorgenommen werden kann, dass eine Materialverformung in einer für den jeweiligen Anwendungsfall erforderlichen Form und Richtung durchgeführt werden kann.

Das Umfassungselement ist vorzugsweise innen zur Anlage am Schutzschichtsystem mit dem dichtenden Teil aus Invar oder höher legierten Stählen hergestellt und das äußere Teil des Umfassungselements ist aus Aluminium hergestellt.

Für das elektromagnetische Umformen des äußeren Teils des Umfassungselements können nur metallische Materialien mit hoher elektrischer Leitfähigkeit verwendet werden, beispielsweise Aluminium oder unlegierte Stähle. Da jedoch für die Anbindung des Schutzschichtsystems an die Anbindeteile Aktorkopf und Aktorfuß eine Dichtheit gegenüber dem äußeren Medium auch bei höheren Temperaturen gewährleistet werden muss, ist Aluminium mit seinem relativ hohen thermischen Ausdehnungskoeffizienten als alleiniges Umfassungselement nicht der bevorzugte Werkstoff; Aluminium dehnt sich nämlich stärker aus als der Piezoaktor bzw. die Anbindeteile Aktorkopf und Aktorfuß aus Stahl. Auch unlegierte Stähle sind aufgrund ihrer fehlenden Korrosionsbeständigkeit, vor allem in nasser Umgebung, nicht die bevorzugten Werkstoffe. Geeignete Werkstoffe für die zu erreichenden Dichtheit innen am Piezoaktor, wie beispielsweise Invarlegierungen oder höher legierte Stähle wiederum besitzen keine ausreichende elektrische Leitfähigkeit für das elektromagnetische Umformen.

Die erfindungsgemäße Lösung dieses Zielkonfliktes sieht die Verwendung eines äußeren Teils, zum Beispiel als Treiberring, aus elektrisch gut leitendem Material, beispielsweise Aluminium, vor. Dieser sogenannte Treiberring wird dann über das zur Abdichtung vorgesehenen innere Teil geschoben und bewirkt während des Verfahrens durch seine Beschleunigung und plastische Verformung eine ebenfalls plastische Verformung des inneren Teils aus schlecht leitendem Material (z.B. Invar oder höher legierter Stahl). Der äußere Treiberring kann nach dem Fügeprozess entweder am Piezoaktor bzw. am Piezoaktormodul verbleiben oder wahlweise entfernt werden.

Alternativ kann auch von vorn herein ein Doppelring verwendet werden, der innen aus dem gewünschten Abdichtungsmaterial und außen aus dem Treibermatenal besteht. Das Abdichtungsmaterial kann hierbei auch als sogenannter L-Ring, gegebenenfalls mit einer Beißkante, ausgestaltet sein.

Eine solche erfindungsgemäße Anbindung des Schutzschichtsystems an den Piezoaktor durch Aufbringen und Anfügen eines Umfassungselements mittels elektromagnetischer Umformung ist besonders dann vorteilhaft, wenn ein Verschweißen oder Löten nicht möglich ist oder allgemein durch das Fügen keine hohen Temperaturen entstehen dürfen, insbesondere bei Verwendung eines Polymers als Schutzschichtsystems, zum Beispiel bei einem Form- oder Schrumpfschlauch.

Bei einem erfindungsgemäßen Verfahren zur Herstellung eines zuvor beschriebenen Piezoaktormoduls werden in vorteilhafter Weise in einem ersten Verfahrensschritt der Piezoaktor und zumindest Teile des Aktorkopfes und/oder des Aktorfußes mit dem Schutzschichtsystem beschichtet, in einem zweiten Verfahrensschritt wird das Umfassungselement, bestehend aus dem inneren und dem äußeren Teil auf das Schutzschichtsystem im Bereich des Aktorkopfs und/oder des Aktorfußes geführt und in einem dritten Verfahrensschritt wird mit dem elektromagnetischen Umformverfahren das äußere Teil des Umfassungselements auf das innere Teil geformt oder gepresst und dadurch das innere Teil dichtend an das Schutzschichtsystem am Aktorkopf und/oder am Aktorfuß angedrückt.

Die Anbindung des Schutzschichtsystems erfolgt dabei bevorzugt mittels der EMPT (elektromagnetische Pulstechnologie) oder sonstiger elektromagnetischer Umformverfahren (EMU). Dies ist insbesondere dann vorteilhaft, wenn eine Anbindung des Schutzschichtsystems auf Querschnitten des Piezoaktormoduls notwendig ist, die nicht rund sind.

### Kurze Beschreibung der Zeichnungen

Die Erfindung wird nachfolgend anhand des in den Zeichnungen gezeigten Ausführungsbeispiels erläutert. Dabei zeigen:
- Figur 1: einen Schnitt durch ein Piezoaktormodul mit einem Piezoaktor, einem Aktorkopf, einem Aktorfuß und mit einem den Piezoaktor umfassenden Schutzschichtsystem, das mit Umfassungselementen am Aktorkopf und am Aktorfuß angebunden ist,
- Figur 2: einen Schnitt ausgehend von der Figur 1 mit einer detaillierten Darstellung des Schutzschichtsystems mit den Umfassungselementen,
- Figur 3 und 4: einen Querschnitt eines Umfassungselements nach den Figuren 1 oder 2 mit einem inneren dichtenden Ring und einem äußeren Treibering der mit einer elektromagnetischen Umformung auf den inneren dichtenden Ring gemäß Figur 4 aufgepresst ist und
- Figur 5a bis 5c: Ausführungsbeispiele des Umfassungselements in einer L-förmigen Ausgestaltung.

### Ausführungsformen der Erfindung

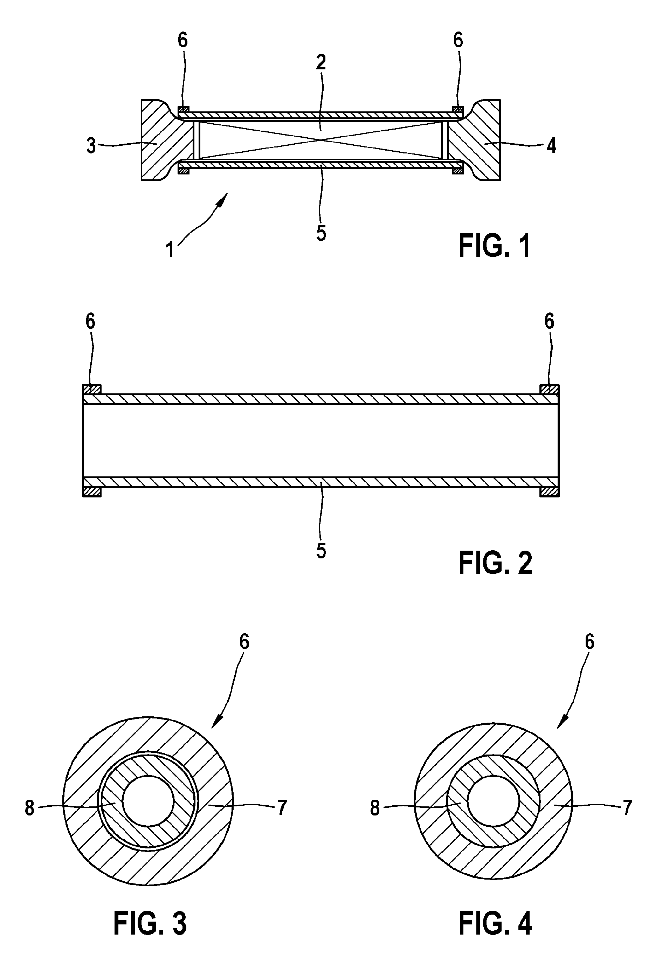

In Figur 1 ist ein Piezoaktormodul 1, beispielsweise für einen Piezoinjektor im Schnitt gezeigt, der zur Nadelhubsteuerung in einem Einspritzsystem für Kraftstoff bei einem Verbrennungsmotor eingesetzt werden kann, wie es eingangs anhand des Standes der Technik beschrieben ist.

Das Piezoaktormodul 1 weist einen Piezoaktor 2 oder eine Aneinanderreihung von mehreren solcher Piezoaktoren 2 auf, die mit den in der Beschreibungseinleitung beschriebenen Piezoelementen zur Bewirkung eines mechanischen Hubs in der Längserstreckung des Piezoaktormoduls 1 aufgebaut sind. An der linken Stirnseite des Piezoaktors 2 ist hier ein Aktorkopf 3 und an der rechten Stirnseite des Piezoaktors 2 ist ein Aktorfuß 4 gezeigt. Der Piezoaktor 2 ist von einem Schutzschichtsystem 5 aus einer oder mehreren Lagen umhüllt, das mittels der Umfassungselemente 6 am Aktorkopf 3 und am Aktorfuß 4 mittels eines elektromagnetischen Umformverfahrens dichtend angebunden ist.

Figur 2 zeigt einen detailierteren Schnitt des Schutzschichtsystems 5 mit den Umfassungselementen 6 und in Figur 3 ist das Umfassungselement 6 mit einem äußeren Teil 7 und einem inneren Teil 8 gezeigt, wobei das innen zur Anlage am Schutzschichtsystem 5 dichtende Teil aus elektrisch schlecht leitendem Material, wie zum Beispiel Invar oder aus höher legierten Stählen, gebildet ist und das äußere Teil 7 hier als Treiberring, beispielsweise aus Aluminium, dient, der mit dem elektromagnetischen Umformverfahren auf das innere Teil 8 aufformbar ist und damit auch den inneren Teil 8 derart gemäß Figur 4 verformt, dass hier quasi ein Dichtring am Schutzschichtsystem 5 und am Aktorkopf 3 und/oder am Aktorfuß 4 gebildet ist.

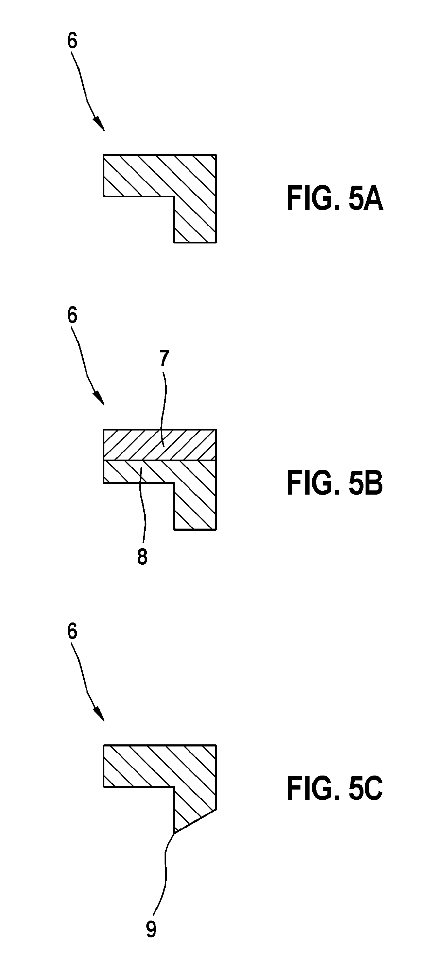

In Figur 5a bis 5c sind noch Ausführungsbeispiele mit L-förmigen Umfassungselementen 6 gezeigt, wobei die Figur 5a eine Variante ohne einen Treiberring darstellt, die Figur 5b eine Variante mit einem Treiberring 7 über dem inneren Teil 8 und die Figur 5c ein Umfassungselement 6 mit einer Beißkante 9 zeigt.

Das für sich gesehen aus dem Stand der Technik bekannte elektromagnetische Umformverfahren kann dabei so ausgeführt werden, dass ein pulsierender hoher Strom von einem Pulsgenerator erzeugt und in eine Spule geführt wird, wobei die Spule im Bereich des äußeren Teils 7 des Umfassungselements 6 angeordnet ist. Hierdurch erfährt das äußere Teil 7 eine radiale Beschleunigung, mit der es auf das innere Teil 8 gepresst wird.

Somit kann mittels des auf das Piezoaktormodul 1 aufgepressten inneren Teils 8 als Dichtring ein Schutz des Piezoaktors 2 im Inneren des Piezoaktormoduls 1 vor den äußeren an dem Schutzschichtsystem 5 vorbeiströmenden aggressiven Medien bei einem Einsatz als Piezoinjektor bewirkt werden.

## Patentansprüche

1. Piezoaktormodul mit einem oder mehreren Piezoaktoren (2), der oder die zwischen einem Aktorkopf (3) und einem Aktorfuß (4) eingespannt sind und wobei zumindest der Piezoaktor (2) mit einem Schutzschichtsystem (5) versehen ist, **dadurch gekennzeichnet, dass** mindestens ein Umfassungselement (6) zur dichten Befestigung des Schutzschichtsystems (5) am Aktorkopf (3), am Aktorfuß (4) und/oder am Piezoaktor (2) vorgesehen ist, das innen zur Anlage am Schutzschichtsystem (5) ein dichtendes Teil (8) aus elektrisch schlecht leitendem Material und außen ein Teil (7) aus elektrisch gut leitendem Material aufweist, das durch elektromagnetisches Umformen auf das innere Teil (8) pressbar ist.

2. Piezoaktormodul nach Anspruch 1, **dadurch gekennzeichnet, dass** das Umfassungselement (6) innen zur Anlage am Schutzschichtsystem (5) mit dem dichtenden Teil (8) aus Invar oder höher legierten Stählen hergestellt ist.

3. Piezoaktormodul nach Anspruch 1 oder 2, **dadurch gekennzeichnet, dass** das äußere Teil (7) des Umfassungselements (6) aus Aluminium hergestellt ist.

4. Piezoaktormodul nach einem der vorhergehenden Ansprüche, **dadurch gekennzeichnet, dass** das Umfassungselements (6) einen L-förmigern Querschnitt mit einem außen über die Kante des Schutzschichtsystems (5) herüberragenden Bereich aufweist.

5. Piezoaktormodul nach Anspruch 4, **dadurch gekennzeichnet, dass** der über die Kante des Schutzschichtsystems (5) herüberragende Bereich eine Beißkante (9) aufweist.

6. Piezoaktormodul nach einem der vorhergehenden Ansprüche, **dadurch gekennzeichnet, dass** das äußere Teil (7) des Umfassungselements (6) nach dem elektromagnetischen Umformen entfernt ist.

7. Piezoaktormodul nach einem der vorhergehenden Ansprüche, **dadurch gekennzeichnet, dass** das Schutzschichtsystem (5) aus einer oder mehreren Schichten eines polymeren oder metallischen Materials besteht.

8. Piezoaktormodul nach einem der vorhergehenden Ansprüche, **dadurch gekennzeichnet, dass** das Piezoaktormodul (1) einen rechteckigen oder sonst wie nichtrunden Querschnitt aufweist.

9. Verfahren zur Herstellung eines Piezoaktormoduls nach einem der vorhergehenden Ansprüche, **dadurch gekennzeichnet, dass** in einem ersten Verfahrensschritt der Piezoaktor (2) und zumindest Teile des Aktorkopfes (3) und/oder des Aktorfußes (4) mit dem Schutzschichtsystem (5) beschichtet werden, in einem zweiten Verfahrensschritt das Umfassungselement (6), bestehend aus dem inneren (8) und dem äußeren Teil (7) auf das Schutzschichtsystem (5) im Bereich des Aktorkopfs (3) und/oder des Aktorfußes (4) geführt wird und in einem dritten Verfahrensschritt mit dem elektromagnetischen Umformverfahren das äußere Teil (7) des Umfassungselements (6) auf das innere Teil (8) geformt oder gepresst wird und **dadurch** das innere Teil (8) dichtend das Schutzschichtsystem (5) am Aktorkopf (3) und/oder am Aktorfuß (4) andrückt.

10. Verfahren nach Anspruch 9, **dadurch gekennzeichnet, dass** das äußere Teil (7) des Umfassungselements (6) nach dem elektromagnetischen Umformverfahren entfernt wird.

11. Verfahren nach Anspruch 9 oder 10, **dadurch gekennzeichnet, dass** das elektromagnetischen Umformverfahren ein Verfahren der elektromagnetischen Pulstechnologie (EMPT) ist.

12. Verwendung eines Piezoaktormoduls nach einem der vorhergehenden Ansprüche, **dadurch gekennzeichnet, dass** der Piezoaktor (2) Bestandteil eines Piezoinjektors für ein Einspritzsystem für Kraftstoff bei einem Verbrennungsmotor ist, wobei der Kraftstoff das Schutzschichtsystem umströmt.
